(19) **Europäisches Patentamt / European Patent Office / Office européen des brevets**

(11) **EP 3 369 172 B1**

(12) **FASCICULE DE BREVET EUROPEEN**

(45) Date de publication et mention de la délivrance du brevet:
**06.11.2019 Bulletin 2019/45**

(21) Numéro de dépôt: **16787387.6**

(22) Date de dépôt: **20.10.2016**

(51) Int Cl.:
*H03B 17/00* (2006.01)   *H03B 23/00* (2006.01)
*G02F 1/11* (2006.01)   *G02F 1/125* (2006.01)
*G02F 1/225* (2006.01)   *H01S 3/00* (2006.01)

(86) Numéro de dépôt international:
**PCT/EP2016/075249**

(87) Numéro de publication internationale:
**WO 2017/072025 (04.05.2017 Gazette 2017/18)**

(54) **DISPOSITIF DE GÉNÉRATION PHOTONIQUE DE SIGNAUX MICRO-ONDES À MODULATION LINÉAIRE DE FRÉQUENCE ARBITRAIRES**

VORRICHTUNG ZUR FOTONISCHEN ERZEUGUNG BELIEBIGER MIKROWELLENSIGNALE MIT LINEARER FREQUENZMODULATION

DEVICE FOR PHOTONIC GENERATION OF ARBITRARY MICROWAVE SIGNALS HAVING LINEAR FREQUENCY MODULATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.10.2015 FR 1560294**

(43) Date de publication de la demande:
**05.09.2018 Bulletin 2018/36**

(73) Titulaires:
- **Centre National de la Recherche Scientifique 75016 Paris (FR)**
- **Université Grenoble Alpes 38400 Saint-Martin-d'Hères (FR)**
- **Institut National de la Recherche Scientifique Québec, QC G1K 9A9 (CA)**

(72) Inventeurs:
- **GUILLET DE CHATELLUS, Hugues 38700 Corenc (FR)**
- **AZANA, José Montreal, Québec H2T 2G1 (CA)**

(74) Mandataire: **Bréda, Jean-Marc Marks & Clerk France Conseils en Propriété Industrielle Immeuble " Visium " 22 Avenue Aristide Briand 94117 Arcueil Cedex (FR)**

(56) Documents cités:
**CN-A- 102 255 224     US-A1- 2007 189 341
US-B1- 7 777 940**

## Description

Le domaine de l'invention est celui de la génération photonique de signaux micro-ondes et plus spécifiquement, de signaux micro-ondes à modulation linéaire de fréquence, encore appelé « MLF ». Ces signaux MLF sont également appelés « arbitraires ». Dans la suite du texte, le terme « MLF » désigne la forme temporelle du signal. Ces signaux sont également connus sous le terme anglo-saxon de « chirp ». Ces signaux se caractérisent par leur fréquence centrale ou moyenne, parfois dénommée fréquence de porteuse et par leur bande passante. Celle-ci est définie classiquement par la différence entre la fréquence la plus élevée et la fréquence la plus basse du signal. Dans le cas présent, la fréquence de porteuse est comprise entre 1 GHz et 100 GHz et la bande passante entre 0 et 200 GHz.

Les domaines d'application de ce type de signaux micro-ondes sont nombreux et divers. On citera, à titre d'exemples, le domaine des radars, celui de l'imagerie biomédicale, celui de la santé, celui de la spectroscopie et enfin, celui de la caractérisation de composants radiofréquence.

Les radars à compression d'impulsions permettent d'obtenir une très bonne résolution spatiale, plus courte que la longueur correspondant à la durée de l'impulsion. On évite ainsi les inconvénients liés à la génération, l'amplification et l'émission d'impulsions courtes et intenses. Les signaux émis par ces radars à compression d'impulsions sont de signaux micro-ondes à modulation linéaire de fréquence. Il en est de même des radars connus sous l'acronyme « FMCW », signifiant « Frequency Modulation Continuous Wave ». Ce type de radar peut notamment être utilisé, dans le domaine de la santé, pour réaliser de la surveillance sans contact de paramètres physiologiques comme le rythme cardiaque.

En imagerie biomédicale, les signaux micro-ondes à modulation linéaire de fréquence permettent d'accéder aux propriétés des tissus biologiques par la mesure de leur permittivité diélectrique. De plus, il est possible de travailler sur des signaux de faible énergie.

Ces signaux sont également particulièrement bien adaptés à la spectroscopie des macromolécules à l'état gazeux comme les acides aminés ou les chaînes de peptides.

Enfin, on peut utiliser ces signaux pour la caractérisation de composants radiofréquence de tous types. Les équipements actuels de type « SNA », acronyme signifiant « Scalar Network Analyser » ou de type « VNA », acronyme signifiant « Vector Network Analyser » qui réalisent ce type de caractérisation sont généralement des équipements lourds et onéreux.

Traditionnellement, les signaux arbitraires sont créés à partir de générateurs arbitraires de fonctions, connus sous l'acronyme « AWG », signifiant « Arbitrary Waveform Generator ». Cependant, leur bande passante est limitée par les convertisseurs analogiques numériques à 40-100GHz. Par ailleurs, l'utilisation des AWG est limitée par leur coût, la fluctuation des instants d'émission des signaux ou « jitter » temporel, l'encombrement et la consommation électrique des appareils.

Plus spécifiquement, la génération des signaux arbitraires est mise en œuvre par un simple « VCO », acronyme signifiant « Voltage Controlled Oscillator » qui génère un signal de fréquence proportionnel à la tension d'entrée. Le principal inconvénient de cette technique est que les bandes passantes obtenues sont limitées à quelques GHz. Par ailleurs, ce type de générateur peut être parasité par d'autres sources micro-ondes.

Pour dépasser les limitations intrinsèques de la bande passante des systèmes électroniques dues à la vitesse des convertisseurs analogiques-numériques, un nouveau domaine de recherche, appelé photonique micro-ondes, encore appelé « microwave photonics » s'est développé depuis une dizaine d'années. On se reportera à l'article de J. Yao intitulé « Microwave photonics », J. Lightwave Tech. (2009) pour des renseignements complémentaires sur cette technique. Le principe est d'utiliser la bande passante très importante des systèmes optiques fibrés qui peut être supérieure à 10 THz, puis de reporter cette bande passante dans le domaine de fréquences des micro-ondes. Pour donner un exemple simple, le battement de deux lasers fibrés sur un photodétecteur produit un signal micro-onde dont la fréquence est égale à la différence des fréquences optiques des deux lasers. On obtient ainsi un signal dans la gamme GHz-THz. Par ailleurs, les techniques optiques sont insensibles aux interférences électromagnétiques, ont une consommation électrique faible et un encombrement réduit. Enfin, la pureté spectrale des trains d'impulsion optiques liée en général à la stabilité mécanique des cavités laser permet d'obtenir un jitter temporel inférieur à celui des méthodes électroniques.

Pour générer des signaux à MLF à des fréquences supérieures au GHz, plusieurs solutions photoniques ont été proposées.

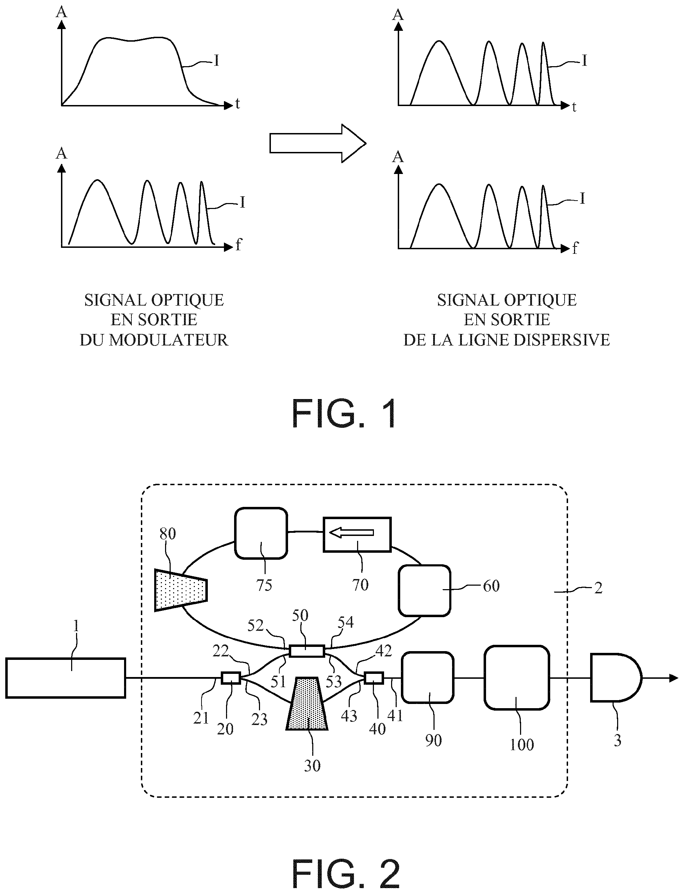

La première solution est l'utilisation de la technique dite « FTTM », acronyme signifiant « Frequency To Time Mapping » dans des lignes optiques dispersives. Un laser de type picoseconde ou femtoseconde à modes bloqués génère une impulsion brève à spectre optique large. Un filtre fréquentiel imprime une modulation du spectre du signal en forme de chirp. La partie gauche de la figure 1 représente l'amplitude A de cette impulsion en fonction du temps t et en fonction de la fréquence f. Cette impulsion est envoyée dans une ligne dispersive dite GVD, acronyme de « Group Velocity Dispersion ». A la sortie de la ligne dispersive, la forme temporelle de l'impulsion reproduit la forme spectrale de l'impulsion comme on le voit sur la partie droite de la figure 1. On a ainsi généré un signal MLF ou chirp. A titre de variante, on peut réaliser ce type de signal optique à partir d'une source incohérente. Cette solution souffre d'une certaine complexité.

Une variante de cette première solution technique consiste à moduler le spectre par une fonction cosinus, puis à la faire propager dans un milieu dont la dispersion est non-linéaire. Ce milieu peut être un réseau de Bragg « chirpé » de façon non-linéaire. Cette technique a plusieurs limitations. On ne peut ni obtenir de grandes bandes passantes, ni modifier simplement la durée du signal ou générer des variations de fréquence croissantes avec le temps.

Une seconde variante consiste à moduler le spectre optique dans un interféromètre dispersif. L'impulsion laser préalablement étirée est injectée dans un interféromètre dans lequel les deux bras ont des dispersions de vitesse de groupe différentes. En sortie, le spectre présente des cannelures dont l'espacement varie linéairement, ce qui se traduit, dans le domaine temporel par une modulation linéaire de fréquence de l'intensité lumineuse de l'impulsion. Cette technique présente certains avantages sur les solutions précédentes. Cependant, le système nécessite toujours un laser à modes bloqués et la durée de la MLF n'est pas ajustable simplement.

Dans une troisième variante, on module l'impulsion issue du laser non seulement en amplitude, mais également en phase. Cette dernière technique permet d'obtenir des bandes passantes importantes mais présente toujours des inconvénients importants. Le taux de répétition reste limité, la durée comme le sens de la variation de fréquence ne sont pas ajustables. Les moyens à mettre en œuvre, en particulier le laser femtoseconde et le modulateur restent complexes et onéreux.

Une seconde solution technique pour générer des signaux micro-ondes à MLF consiste à utiliser deux lasers. Dans une première configuration, le premier laser émet un signal continu et mono-fréquence et l'impulsion du second laser a subi une MLF. Le battement de ces deux lasers sur un photodétecteur reproduit la MLF optique dans le domaine des micro-ondes. Les avantages de cette technique sont une relative simplicité et la capacité à ajuster la durée du signal, la plage de variation de sa fréquence centrale et de sa bande passante. En contrepartie, la linéarité de la MLF du laser est problématique pour des bandes passantes importantes.

Une variante de cette seconde solution consiste à propager une impulsion courte émise par le premier laser dans un milieu dispersif de façon à disperser les fréquences contenues dans l'impulsion. L'impulsion dispersée est ensuite recombinée avec le second laser. Cette technique donne des performances intéressantes au prix d'une complexité technique supérieure, d'un coût important et d'une flexibilité moindre. Une variante de cette technique consiste à faire battre deux lasers ayant subi deux propagations dispersives différentes et donc deux chirps optiques différents.

Cependant, malgré leur flexibilité, à cause de l'absence de stabilisation possible de fréquences et à plus forte raison de phase entre les deux lasers, les techniques utilisant deux lasers sont rédhibitoires pour les applications où une grande reproductibilité du signal est nécessaire et en particulier pour les applications radar où la cohérence d'impulsion à impulsion est nécessaire.

Le document de brevet chinois CN102255224 divulgue un modulateur micro-ondes à base d'un réseau ultrasonique qui opère en tant que décaleur acousto-optique.

Le documents de brevet américains US2007/189341 et US7777940 divulguent des générateurs de signaux chirp à base d'un réseau de Bragg.

Plus précisément, l'invention a pour objet un dispositif de génération photonique de signaux microondes arbitraires modulés linéairement en fréquence, ledit dispositif comprenant, dans cet ordre, un laser émettant un signal continu à une première fréquence optique, un ensemble de mise en forme spectrale et temporelle dudit signal continu et un photorécepteur dont la bande passante est dans le domaine des fréquences microondes, caractérisé en ce que l'ensemble de mise en forme spectrale et temporelle comporte au moins :

- Un premier séparateur optique en Y disposé à la sortie du laser ;
- Une première voie optique disposée à la sortie de la première branche du premier séparateur optique en Y, ladite première voie optique étant une boucle à décalage de fréquence, ladite boucle à décalage de fréquence comprenant un séparateur optique en X, un premier amplificateur optique, un premier filtre optique, un isolateur optique et un décaleur acousto-optique de fréquences disposés entre deux branches du séparateur optique en X ;
- Une seconde voie optique disposée à la sortie de la seconde branche du premier séparateur optique Y, ladite seconde voie optique comportant un décaleur électro-optique de fréquences ;
- Un second séparateur optique en Y dont la première branche est disposée à la sortie de la première voie optique et la seconde branche à la sortie de la seconde voie optique ;
- Un second amplificateur optique disposé à la sortie commune du second séparateur optique en Y ;
- Un second filtre optique disposé entre la sortie du second amplificateur optique et le photorécepteur ;

Au moins la fréquence de décalage acousto-optique, la fréquence de décalage électro-optique et le gain d'amplification du premier amplificateur optique étant réglables.

Avantageusement, tout ou partie du dispositif est fibré, le laser étant fibré, le premier séparateur optique en Y étant un premier coupleur optique en Y, le second séparateur optique en Y étant un second coupleur optique en Y et le séparateur optique en X étant un coupleur optique en X.

Avantageusement, tout ou partie du dispositif est réalisé en optique intégrée.

Avantageusement, tout ou partie du dispositif est réalisé au moyens de composants optiques discrets, le premier séparateur optique en Y étant un premier cube séparateur comportant une lame semi-réfléchissante, le second séparateur optique en Y étant un second cube séparateur comportant une lame semi-réfléchissante et le séparateur optique en X étant un cube séparateur comportant une lame semi-réfléchissante.

Avantageusement, le premier filtre optique de type passe-bande optique.

Avantageusement, le second filtre optique est un filtre spectral de type passe-bande optique ou un filtre à modulation d'intensité.

Avantageusement, le produit de la fréquence de décalage acousto-optique par le temps de parcours par la lumière de la boucle à décalage de fréquence est sensiblement égal à un nombre entier ou à un nombre fractionnaire.

Avantageusement, la fréquence de décalage acousto-optique est comprise entre 1 et 300 MHz.

Avantageusement, le décaleur électro-optique de fréquences est un modulateur à bande latérale unique.

Avantageusement, la fréquence de décalage électro-optique est comprise entre -40 GHz et +40 GHz.

Avantageusement, le gain du premier amplificateur est au moins suffisant pour compenser les pertes optiques dans le séparateur optique en X, l'isolateur optique, le décaleur acousto-optique de fréquences et le filtre optique spectral.

L'invention sera mieux comprise et d'autres avantages apparaîtront à la lecture de la description qui va suivre donnée à titre non limitatif et grâce aux figures annexées parmi lesquelles :

La figure 1 déjà commentée est l'illustration de la technique dite « FTTM », acronyme signifiant « Frequency To Time Mapping » de génération de signaux micro-ondes à modulation linéaire de fréquence dans des lignes dispersives selon l'art antérieur ;
La figure 2 représente un synoptique général d'un dispositif de génération photonique de signaux microondes arbitraires modulés linéairement en fréquence selon l'invention incluant une boucle à décalage de fréquence ;
La figure 3 représente le signal initial en fonction de la fréquence dans un dispositif selon l'invention ;
La figure 4 représente un premier signal en fonction de la fréquence à la sortie de la boucle à décalage de fréquence dans un dispositif selon l'invention ;
La figure 5 représente un second signal en fonction de la fréquence à la sortie de la boucle à décalage de fréquence dans un dispositif selon l'invention ;
La figure 6 représente le signal en fonction de la fréquence en sortie du décaleur électro-optique de fréquences dans un dispositif selon l'invention ;
La figure 7 représente la courbe de transmission du premier filtre optique en fonction de la fréquence dans un dispositif selon l'invention ;
La figure 8 représente le signal périodique en fonction du temps en sortie du photorécepteur dans un dispositif selon l'invention, dans le cas où le rapport $f_s/f_c$ est voisin d'un rapport d'entiers ;
Les figures 9 et 10 représentent le signal en fonction du temps et en fonction du décalage de fréquence dans un dispositif selon l'invention.

Le dispositif de génération photonique de signaux microondes selon l'invention peut être réalisé soit dans une configuration « fibrée » ou d'optique intégrée, la boucle à décalage de fréquence étant constituée de fibres optiques ou de guides d'ondes ; soit dans une configuration en « espace libre » avec des composants optiques discrets, la boucle à décalage de fréquence étant réalisée par des miroirs correctement alignés. On entend par configuration en espace libre, une configuration dans laquelle les faisceaux optiques se propagent tout ou partie en espace libre.

Le synoptique d'un dispositif de génération photonique de signaux microondes arbitraires modulés linéairement en fréquence selon l'invention est représentée en figure 2 dans sa version « fibrée ». C'est cette version qui est détaillée ci-dessous. Cependant, chaque fois qu'il existe une différence significative entre la version fibrée et la version en espace libre, elle est signalée.

Le dispositif de génération photonique de la figure 2 comprend dans cet ordre :

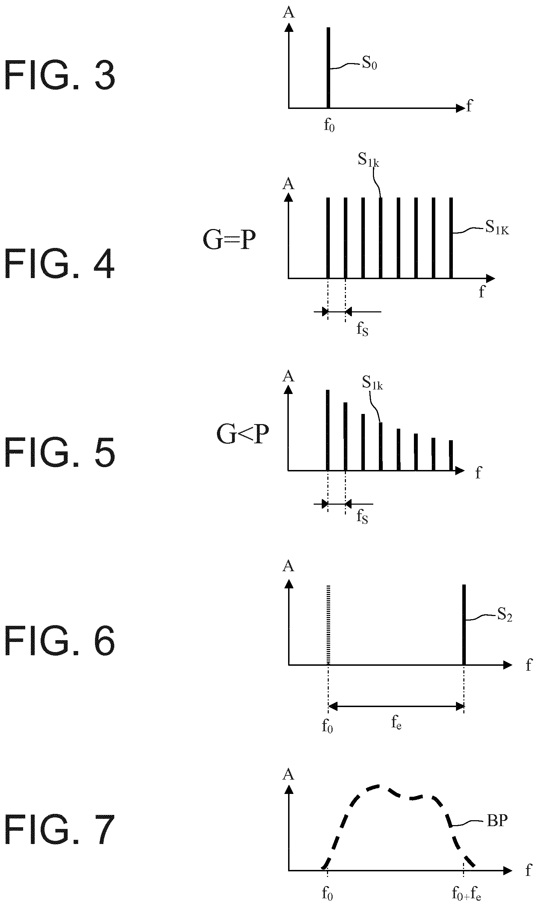

- un laser émettant un signal continu $S_0$ à une première fréquence optique notée $f_0$. Cette fréquence est dans le domaine de quelques centaines de THz. Ce laser peut avantageusement être un laser fibré émettant dans la gamme des fréquences dites « télécom », autour de 1550 nm. Il doit posséder une faible largeur de raie de l'ordre de quelques kHz et émettre une puissance de quelques mW. D'autres longueurs d'onde sont possibles, en particulier au voisinage de 780 nm ou de 1 $\mu$m mais les composants fibrés pour ces longueurs d'onde sont plus onéreux. L'amplitude A de ce signal $S_0$ en fonction de la fréquence f est représentée sur la figure 3. L'utilisation d'un unique laser présente un grand avantage sur les technologies précédentes dans la mesure où la cohérence d'impulsion à impulsion est automatiquement assurée ;
- un ensemble 2 de mise en forme spectrale et temporelle dudit signal continu ;
- un photorécepteur 3 dont la bande passante est dans le domaine des fréquences microondes.

L'ensemble 2 de mise en forme spectrale et temporelle comporte au moins :

- Un premier dispositif séparateur optique 20 en Y. dans le cas de la figure 2, ce séparateur est un coupleur optique. Dans une réalisation en espace libre, ce coupleur est une lame séparatrice ou un cube séparateur. Ce séparateur comporte une entrée 21 et deux branches de sorties 22 et 23. L'entrée 21 est couplée au laser 1, la sortie 22 est couplée à la première voie optique et la sortie 23 à la seconde voie optique ;

- Une première voie optique disposée à la sortie de la première branche 22 du premier coupleur 20. Cette première voie optique est une boucle à décalage de fréquence. Elle comprend un dispositif séparateur optique 50 en X, un premier amplificateur optique 60, un isolateur optique 70, un premier filtre spectral optique 75 et un décaleur acousto-optique de fréquences 80.

◦ Le séparateur optique 50 en X peut être un coupleur à fibres optiques optique à quatre voies ou un séparateur optique réalisé au moyen d'une lame semi-réfléchissante. Le coupleur 50 en X comporte deux voies d'entrée 51 et 52 et deux voies de sorties 53 et 54. L'entrée 51 est couplée à la sortie 22 du coupleur Y.

◦ L'amplificateur 60, l'isolateur 70, le filtre spectral 75 et le décaleur acousto-optique 80 sont montés en série entre la sortie 54 et l'entrée 52 du coupleur en X. L'amplificateur 60 a un gain noté G, l'ensemble des pertes optiques dans la première voie dues aux différents couplages optiques et aux pertes dans l'isolateur et le décaleur acousto-optique 80 est noté P.

◦ Le rôle de l'isolateur optique 70 est de forcer la lumière issue du laser à se propager dans un sens unique, évitant ainsi que des ondes parasites circulent dans l'autre sens et viennent perturber le fonctionnement du système.

◦ Le premier filtre spectral optique 75 a pour but principal de limiter le bruit dû à l'émission spontanée amplifiée et accessoirement, de pouvoir sélectionner la bande passante de la boucle et donc de contrôler la largeur spectrale du signal modulé en fréquence. Ce filtre optique programmable repose sur un réseau de Bragg photo-inscrit dans une fibre optique, ou bien sur un élément diffractif ou réseau optique permettant d'accéder au spectre de la lumière dans le plan de Fourier du dispositif. Un filtre d'amplitude programmable, habituellement une matrice à cristaux liquides, placé dans ce plan de Fourier, permet d'atténuer sélectivement les différentes fréquences de la lumière et donc de moduler son spectre. Un deuxième passage dans le réseau permet de recollimater la lumière après modulation de son spectre, et de la réinjecter soit dans la boucle en espace libre, soit dans une fibre optique dans le cas d'une configuration fibrée.

◦ Le décaleur acousto-optique 80 utilise la diffraction de l'onde lumineuse par une onde acoustique progressive dans un solide transparent. La fréquence de décalage acousto-optique $f_S$ est comprise entre 1 et 300 MHz. Cette gamme de fréquences est tout à fait classique pour ce type de dispositif.

◦ On appelle $f_C$ l'inverse du temps de parcours dans la boucle à décalage de fréquence. Dans le cas d'une configuration fibrée, si la longueur de la boucle à décalage de fréquence est de 10 mètres, la fréquence $f_C$ de cette boucle vaut 30 MHz. Cette fréquence est de 10 MHz pour une longueur de boucle de 30 mètres. L'ordre de grandeur de cette fréquence est équivalent à celui de la fréquence de décalage acousto-optique $f_S$. Ces ordres de grandeur de longueur de boucle sont naturellement ceux que l'on obtient en utilisant des amplificateurs à fibre dopée erbium 60. Dans le cas d'une configuration en espace libre, la longueur de la boucle peut être significativement plus faible, de quelques dizaines de centimètres à quelques mètres. Les valeurs de $f_c$ sont alors plus élevées et varient entre 100 MHz et 1 GHz.

- Une seconde voie optique est disposée à la sortie de la seconde branche 23 du premier dispositif séparateur Y. Cette seconde voie optique comporte un décaleur 30 électro-optique de fréquences. Ce décaleur de fréquences est préférentiellement un modulateur à bande latérale unique. Ce décaleur utilise habituellement deux interféromètres de Mach-Zehnder contenant chacun un modulateur électro-optique. En ajustant correctement les tensions des modulateurs électro-optiques de manière à faire interférer destructivement à la fois la porteuse et une des deux bandes latérales, on obtient en sortie une seule bande latérale : ce dispositif fonctionne donc comme un décaleur de fréquence. La fréquence de décalage électro-optique $f_e$ est comprise entre -40 GHz et +40 GHz dans une configuration fibrée. Cette gamme de fréquences est tout à fait classique pour ce type de dispositif.

- Un second dispositif séparateur optique 40 en Y. Ce séparateur comporte deux branches d'entrée 42 et 43 et une sortie unique 41. Là encore, ce séparateur peut être un coupleur optique fibrée ou une lame semi-réfléchissante. La première branche d'entrée 42 est couplée à la sortie 53 du coupleur en X de la première voie, la seconde branche d'entrée sortie 43 est couplée à la sortie du décaleur 30 électro-optique de fréquences ;

- Un second amplificateur optique 90 disposé à la sortie commune 41 du second séparateur optique en Y.

- Un second filtre optique 100 disposé entre la sortie du second amplificateur optique 90 et le photorécepteur 3. Ce filtre peut être un filtre programmable qui fonctionne sur le même principe que le filtre spectral 75. Bien entendu, la bande de filtrage du filtre optique doit être compatible de la fréquence optique $f_0$. Alternativement, à cause de la relation linéaire entre le temps et la fréquence instantanée dans le cas de signaux à modulation linéaire de fréquence, ce filtre peut aussi être un modulateur d'intensité, qui permet de contrôler temporellement l'intensité du signal lumineux à la sortie de la boucle. En général, ce modulateur d'intensité est basé soit sur un modulateur acousto-optique, soit sur de la modulation électro-optique. Cette dernière peut elle-même être basée sur la rotation de polarisation par effet Pockels, ou sur un effet d'interférence dans un interféromètre de Mach-Zehnder.

Au moins, la fréquence de décalage acousto-optique $f_S$, la fréquence de décalage électro-optique $f_e$ et le gain G d'amplification du premier amplificateur optique sont réglables. La fréquence $f_S$ est ajustée, par exemple, au moyen d'un générateur de radiofréquences.

Le fonctionnement du dispositif de génération photonique est détaillé ci-dessous.

Une première partie du faisceau émis à la fréquence $f_0$ est introduit dans la boucle à décalage de fréquence. Son fonctionnement est le suivant. Chaque fois que le faisceau fait un tour complet de la boucle et revient à l'entrée 52 du coupleur en X, une partie du faisceau est réinjecté dans la boucle par le coupleur en X, la seconde partie sort de la boucle et passe dans l'amplificateur optique 90. A la sortie 53 du coupleur en X, on obtient donc un signal optique $S_1$ composé d'une succession de signaux optiques $S_{1k}$ ayant traversé un certain nombre de fois k la boucle.

Chaque signal $S_{1k}$ est caractérisé par son amplitude, sa fréquence et sa phase. Les figures 4 et 5 représentent les amplitudes de la succession de signaux $S_{1k}$ en fonction de la fréquence. L'amplitude du signal $S_{1k}$ dépend du gain de l'amplificateur optique 60, du premier filtre optique 75 et des pertes dans la boucle. Si le gain compense juste les pertes, tous les signaux $S_{1k}$ ont même amplitude comme on le voit sur la figure 4. Si le gain est inférieur aux pertes, l'amplitude des signaux $S_{1k}$ s'éteint rapidement comme on le voit sur la figure 5.

Chaque fois que la lumière traverse le décaleur de fréquence acousto-optique 80, sa fréquence est augmentée d'une quantité $f_S$. Ainsi, le signal $S_{1k}$ a une fréquence égale à $f_0 + k.f_S$ comme on le voit sur les figures 4 et 5.

Compte-tenu de l'effet itératif dans la boucle, on démontre que les différentes fréquences ont une dépendance quadratique de leur phase. Plus précisément, la phase $\varphi_{1k}$ du signal $S_{1k}$ de fréquence $f_0 + k.f_S$ vérifie la relation :

$$\varphi_{1k} = \pi.k.(k+1).f_S/f_C$$

On se reportera aux articles de H. Guillet de Chatellus et al, intitulés « Génération of ultrahigh and tunable répétition rates in CW injection seeded frequency shifted feedback lasers », Opt. Exp. 21, 15065 (2013) et « Theory of Talbot lasers », Phys. Rev A 88, 033828 (2013) pour toutes informations sur ce calcul.

Le signal optique $S_1$ est donc équivalent à un peigne de fréquences optiques ayant subi une certaine dispersion de vitesse de groupe qui correspond à la phase spectrale quadratique.

Dans le domaine temporel, ce signal optique consiste en un train d'impulsions lumineuses, identiques et de période $1/f_S$. Chaque impulsion possède une MLF dans le domaine des fréquences optiques dont les fréquences minimale et maximale sont $f_0$ et $f_0 + K.f_S$. où K est le nombre maximal d'allers-retours que fait la lumière dans la boucle, et de façon équivalente, le nombre de fréquences présentes dans le peigne de fréquences optiques à la sortie de la boucle.

Par ailleurs, la dispersion équivalente est proportionnelle à la courbure de la parabole des phases, c'est-à-dire $f_S/f_C$. Ce dernier paramètre est contrôlable facilement en ajustant la fréquence de décalage acousto-optique $f_S$. Comme on le voit dans l'expression de la phase $\varphi_{1k}$, il est intéressant de choisir le rapport $f_S/f_C$ assez proche d'une valeur entière, ou d'un rapport de deux entiers p/q où q est inférieur à K.

Lorsque ce rapport est exactement égal à une valeur entière, la dispersion équivalente est nulle. Toutes les composantes spectrales sont en phase et la boucle émet des impulsions courtes, la limite temporelle étant donnée par la transformée de Fourier du peigne de fréquences. Dans le cas où ce rapport est égal à un rapport d'entiers p/q, avec q<K, la boucle émet des impulsions courtes de même durée que dans le cas du rapport entier mais à un taux de répétition ou nombre d'impulsions par seconde égal à $q*f_S$. La description et l'explication de cet effet sont données dans les deux articles cités plus haut.

En revanche, lorsque ce rapport s'écarte de la valeur entière ou fractionnaire, l'impulsion optique s'élargit temporellement et présente une MLF dont le sens de variation change au passage de l'entier. En effet, on sait qu'aux déphasages dans le domaine spectral correspond des décalages temporels dans le domaine temporel. A une grande diversité de phases dans le domaine spectral, correspond donc un élargissement temporel de l'impulsion résultante.

Une seconde partie du faisceau émis à la fréquence $f_0$ est introduit dans le décaleur 30 électro-optique de fréquences. A la sortie du décaleur de fréquences 30, on obtient un signal optique $S_2$ dont la fréquence est égale à $f_0 + f_e$. L'amplitude de ce signal $S_2$ en fonction de la fréquence est représentée sur la figure 6. Le coupleur en Y 40 reçoit sur ces deux entrées 42 et 43 les signaux $S_1$ et $S_2$ issus respectivement de la boucle à décalage de fréquence et du décaleur électro-optique et les recombinent. Ce signal recombiné comporte donc une fréquence optique centrée sur $f_0 + f_e$ et un peigne de fréquences optiques s'étendant de $f_0$ à $f_0 + K.f_S$.

Le signal recombiné est amplifié par l'amplificateur optique 90, filtré par le filtre 100 et reçu par le photodétecteur 3. On note ce dernier signal optique am-

plifié et filtré $S_3$. La figure 7 représente la bande passante BP du filtre programmable 100, induite soit par un filtrage spectral, soit par une modulation temporelle du signal en sortie de la boucle, selon la solution retenue. On peut aussi remplacer le filtre spectral 100 par un modulateur d'intensité. En effet, à cause de la relation linéaire entre la fréquence et le temps, une modulation temporelle de l'intensité de l'impulsion, synchronisée avec le train d'impulsions est équivalente à un filtrage spectral par le filtre 100. Même si elle est plus complexe à mettre en œuvre dans la mesure où elle nécessite une synchronisation très précise du signal de modulation avec le train d'impulsions, la modulation temporelle de l'intensité permet de s'affranchir d'une limitation du filtre spectral, qui est posée par sa résolution, supérieure à 10 GHz, pour des dispositifs commerciaux du type « waveshaper ».

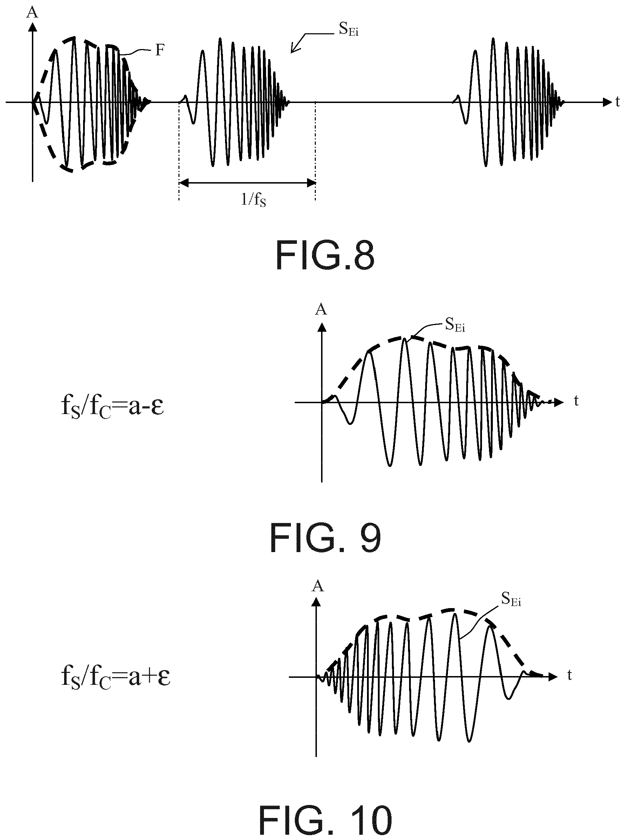

Le signal électrique $S_E$ à la sortie du photodétecteur 3 consiste en un train périodique de signaux $S_{Ei}$. Sa période temporelle est égale à $1/f_S$ quand le rapport $f_S/f_c$ est un entier ou $1/(qf_S)$ quand ce rapport est égal à $p/q$, $p$ et $q$ étant des entiers et $q$ étant inférieur à K. Ce train est représenté sur la figure 8 dans le cas du rapport entier. Dans ce cas, les signaux $S_{Ei}$ sont alors identiques. Chaque signal a une fréquence instantanée qui varie au cours du temps comme on le voit sur la figure 8. Il est à noter que, sur cette figure et les deux suivantes, le signal comporte, pour des raisons de clarté, un nombre réduit de périodes. Les signaux réels ont généralement un nombre de périodes beaucoup plus important.

La bande passante du signal est donnée par la largeur spectrale du signal optique $S_3$. Elle est limitée par la bande passante du filtre 100 et par la largeur spectrale du signal $S_1$ circulant dans la boucle à décalage de fréquence. Comme on l'a dit, celle-ci est liée au gain de l'amplificateur optique 60, au filtre optique spectral 75 et aux pertes dans la boucle. La fréquence centrale est liée à la fréquence optique $f_0 + f_e$ du signal $S_2$. On peut ainsi atteindre des fréquences micro-ondes dans la gamme des 100 GHz.

Il est également possible de modifier le sens de variation de la MLF en modifiant la fréquence $f_S$. On sait que le sens de variation de la MLF change lorsque le rapport $f_S/f_C$ change au passage d'un entier ou d'un rapport d'entiers. Les figures 9 et 10 illustrent cette propriété. Elles représentent l'amplitude A du signal élémentaire $S_{Ei}$ en fonction du temps.

Si a est un nombre entier ou un rapport d'entiers $p/q$ ($q<N$), on appelle alors $\varepsilon$ la différence entre la valeur de a et l'entier ou le rapport d'entiers le plus proche.

Quand $\varepsilon$ est nul, le signal de sortie consiste en impulsions limitées par transformée de Fourier, il n'y a plus de MLF.

Lorsque $\varepsilon$ n'est pas nul, on peut montrer que la durée du signal à MLF est approximativement de l'ordre de $\varepsilon*K/fs$ où K est le nombre total de fréquences dans le peigne de fréquences en sortie de la boucle. Ainsi, lorsque $\varepsilon = +/- 1/K$, la durée du signal à MLF est $1/fs$. Par conséquent, la plage de variation intéressante de $\varepsilon$ est

entre $-1/K$ et $+ 1/K$.

Lorsque le rapport $f_S/f_C$ est légèrement inférieur à a, c'est-à-dire lorsque $\varepsilon$ est négatif, la MLF du signal élémentaire $S_{Ei}$ débute temporellement par les basses fréquences et se termine par les hautes fréquences et lorsque le rapport $f_S/f_C$ est légèrement supérieur à a, c'est-à-dire lorsque $\varepsilon$ est positif, la MLF du signal élémentaire $S_{Ei}$ débute temporellement par les hautes fréquences et se termine par les basses fréquences.

A titre d'exemple, pour un signal $S_{Ei}$ de période 12 ns comportant des fréquences dans une gamme comprise entre 0 et 30 GHz, une variation de fréquence $f_S$ de seulement 80 kHz suffit à modifier le sens de la modulation.

## Revendications

1. Dispositif de génération photonique de signaux microondes arbitraires modulés linéairement en fréquence, ledit dispositif comprenant, dans cet ordre, un laser (1) émettant un signal continu à une première fréquence optique, un ensemble (2) de mise en forme spectrale et temporelle dudit signal continu et un photorécepteur (3) dont la bande passante est dans le domaine des fréquences microondes, **caractérisé en ce que** l'ensemble de mise en forme spectrale et temporelle comporte au moins :

   - Un premier séparateur optique (20) en Y disposé à la sortie du laser ;
   - Une première voie optique disposée à la sortie (22) de la première branche du premier séparateur optique en Y, ladite première voie optique étant une boucle à décalage de fréquence, ladite boucle à décalage de fréquence comprenant un séparateur optique (50) en X, un premier amplificateur optique (60), un premier filtre optique (75), un isolateur optique (70) et un décaleur (80) acousto-optique de fréquences disposés entre deux branches du séparateur optique en X ;
   - Une seconde voie optique disposée à la sortie (23) de la seconde branche du premier séparateur optique Y, ladite seconde voie optique comportant un décaleur (30) électro-optique de fréquences ;
   - Un second séparateur optique (40) en Y dont la première branche (42) est disposée à la sortie de la première voie optique et la seconde branche (43) à la sortie de la seconde voie optique ;
   - Un second amplificateur optique (90) disposé à la sortie commune (41) du second séparateur optique en Y ;
   - Un second filtre optique (100) disposé entre la sortie du second amplificateur optique et le photorécepteur ;

Au moins la fréquence de décalage (80) acousto-optique, la fréquence de décalage (30) électro-optique et le gain d'amplification du premier amplificateur optique (60) étant réglables.

2. Dispositif de génération photonique de signaux microondes arbitraires selon la revendication 1, **caractérisé en ce que** tout ou partie du dispositif est fibré, le laser étant fibré, le premier séparateur optique en Y étant un premier coupleur optique en Y, le second séparateur optique en Y étant un second coupleur optique en Y et le séparateur optique en X étant un coupleur optique en X.

3. Dispositif de génération photonique de signaux microondes arbitraires selon la revendication 1, **caractérisé en ce que** tout ou partie du dispositif est réalisé en optique intégrée.

4. Dispositif de génération photonique de signaux microondes arbitraires selon la revendication 1, **caractérisé en ce que** tout ou partie du dispositif est réalisé au moyens de composants optiques discrets, le premier séparateur optique en Y étant un premier cube séparateur comportant une lame semi-réfléchissante, le second séparateur optique en Y étant un second cube séparateur comportant une lame semi-réfléchissante et le séparateur optique en X étant un cube séparateur comportant une lame semi-réfléchissante.

5. Dispositif de génération photonique de signaux microondes arbitraires selon l'une des revendications précédentes, **caractérisé en ce que** le premier filtre optique (75) est de type passe-bande optique.

6. Dispositif de génération photonique de signaux microondes arbitraires selon l'une des revendications précédentes, **caractérisé en ce que** le second filtre optique (100) est soit un filtre spectral de type passe-bande optique, soit un filtre à modulation d'intensité.

7. Dispositif de génération photonique de signaux microondes arbitraires selon l'une des revendications précédentes, **caractérisé en ce que** le produit de la fréquence de décalage acousto-optique par le temps de parcours par la lumière de la boucle à décalage de fréquence est sensiblement égal à un nombre entier ou à un nombre fractionnaire.

8. Dispositif de génération photonique de signaux microondes arbitraires selon l'une des revendications précédentes, **caractérisé en ce que** la fréquence de décalage acousto-optique est comprise entre 1 et 300 MHz.

9. Dispositif de génération photonique de signaux microondes arbitraires selon l'une des revendications précédentes, **caractérisé en ce que** le décaleur électro-optique de fréquences est un modulateur à bande latérale unique.

10. Dispositif de génération photonique de signaux microondes arbitraires selon l'une des revendications précédentes, **caractérisé en ce que** la fréquence de décalage électro-optique est comprise entre -40 GHz et +40 GHz.

11. Dispositif de génération photonique de signaux microondes arbitraires selon l'une des revendications précédentes, caractérisé en ce le gain du premier amplificateur est au moins suffisant pour compenser les pertes optiques dans le séparateur optique en X, l'isolateur optique, le décaleur acousto-optique de fréquences.

**Patentansprüche**

1. Vorrichtung zum photonischen Erzeugen von beliebigen linear frequenzmodulierten Mikrowellensignalen, wobei die Vorrichtung, in dieser Reihenfolge, Folgendes umfasst: einen Laser (1), der ein kontinuierliches Signal mit einer ersten optischen Frequenz aussendet, eine Baugruppe (2) zur spektralen und zeitlichen Gestaltung des kontinuierlichen Signals, und einen Fotorezeptor (3), dessen Passband im Mikrowellenfrequenzbereich liegt,
**dadurch gekennzeichnet, dass** die Baugruppe zur spektralen und zeitlichen Gestaltung wenigstens Folgendes umfasst:

- einen ersten Y-förmigen optischen Separator (20), der am Ausgang des Lasers angeordnet ist;
- einen ersten optischen Kanal, der am Ausgang (22) des ersten Zweigs des ersten Y-förmigen optischen Separators angeordnet ist, wobei der erste optische Kanal eine Frequenzverschiebungsschleife ist, wobei die Frequenzverschiebungsschleife einen X-förmigen optischen Separator (50), einen ersten optischen Verstärker (60), ein erstes optisches Filter (75), einen optischen Isolator (70) und einen akustooptischen Frequenzschieber (80) umfasst, die zwischen zwei Zweigen des X-förmigen optischen Separators angeordnet sind;
- einen zweiten optischen Kanal, der am Ausgang (23) des zweiten Zweigs des ersten Y-förmigen optischen Separators angeordnet ist, wobei der zweite optische Kanal einen elektrooptischen Frequenzschieber (30) umfasst;
- einen zweiten Y-förmigen optischen Separator (40), dessen erster Zweig (42) am Ausgang des ersten optischen Kanals angeordnet ist und dessen zweiter Zweig (43) am Ausgang des zweiten optischen Kanals angeordnet ist;
- einen zweiten optischen Verstärker (90), der am gemeinsamen Ausgang (41) des zweiten Y-förmigen optischen Separators angeordnet ist;
- ein zweites optisches Filter (100), das zwischen dem Ausgang des zweiten optischen Verstärkers und dem Fotorezeptor angeordnet ist;

wobei wenigstens die akustooptische Verschiebungsfrequenz (80), die elektrooptische Verschiebungsfrequenz (30) und die Verstärkung des ersten optischen Verstärkers (60) regelbar sind.

2. Vorrichtung zur photonischen Erzeugung von beliebigen Mikrowellensignalen nach Anspruch 1, **dadurch gekennzeichnet, dass** die Vorrichtung ganz oder teilweise aus Fasern ist, wobei der Laser aus Fasern ist, wobei der erste Y-förmige optische Separator ein erster Y-förmiger optischer Koppler ist, wobei der zweite Y-förmige optische Separator ein zweiter Y-förmiger optischer Koppler ist und der X-förmige optische Separator ein X-förmiger optischer Koppler ist.

3. Vorrichtung zur photonischen Erzeugung von beliebigen Mikrowellensignalen nach Anspruch 1, **dadurch gekennzeichnet, dass** die Vorrichtung ganz oder teilweise in integrierter Optik realisiert ist.

4. Vorrichtung zur photonischen Erzeugung von beliebigen Mikrowellensignalen nach Anspruch 1, **dadurch gekennzeichnet, dass** die Vorrichtung ganz oder teilweise mittels diskreter Optikkomponenten realisiert ist, wobei der erste Y-förmige optische Separator ein erster Separatorwürfel ist, der eine teilreflektierende Lamelle umfasst, wobei der zweite Y-förmige optische Separator ein zweiter Separatorwürfel ist, der eine teilreflektierende Lamelle umfasst, und der X-förmige optische Separator ein Separatorwürfel ist, der eine teilreflektierende Lamelle umfasst.

5. Vorrichtung zur photonischen Erzeugung von beliebigen Mikrowellensignalen nach einem der vorherigen Ansprüche, **dadurch gekennzeichnet, dass** das erste optische Filter (75) vom optischen Passbandtyp ist.

6. Vorrichtung zur photonischen Erzeugung von beliebigen Mikrowellensignalen nach einem der vorherigen Ansprüche, **dadurch gekennzeichnet, dass** das zweite optische Filter (100) entweder ein Spektralfilter vom optischen Passbandtyp oder ein Intensitätsmodulationsfilter ist.

7. Vorrichtung zur photonischen Erzeugung von beliebigen Mikrowellensignalen nach einem der vorherigen Ansprüche, **dadurch gekennzeichnet, dass** das Produkt aus der akustooptischen Verschiebungsfrequenz multipliziert mit der Zeit, die das Licht zum Durchlaufen der Frequenzverschiebungsschleife benötigt, im Wesentlichen gleich einer ganzen Zahl oder einer Bruchzahl ist.

8. Vorrichtung zur photonischen Erzeugung von beliebigen Mikrowellensignalen nach einem der vorherigen Ansprüche, **dadurch gekennzeichnet, dass** die akustooptische Verschiebungsfrequenz zwischen 1 und 300 MHz liegt.

9. Vorrichtung zur photonischen Erzeugung von beliebigen Mikrowellensignalen nach einem der vorherigen Ansprüche, **dadurch gekennzeichnet, dass** der elektrooptische Frequenzschieber ein Modulator mit einem einzigen Seitenband ist.

10. Vorrichtung zur photonischen Erzeugung von beliebigen Mikrowellensignalen nach einem der vorherigen Ansprüche, **dadurch gekennzeichnet, dass** der elektrooptische Frequenzschieber zwischen -40 GHz und +40 GHz liegt.

11. Vorrichtung zur photonischen Erzeugung von beliebigen Mikrowellensignalen nach einem der vorherigen Ansprüche, **dadurch gekennzeichnet, dass** die Verstärkung des ersten Verstärkers wenigstens ausreicht, um die optischen Verluste in dem X-förmigen optischen Separator, dem optischen Isolator, dem akustooptischen Frequenzschieber zu kompensieren.

**Claims**

1. A device for photonic generation of linearly frequency modulated arbitrary microwave signals, said device comprising, in this order, a laser (1) emitting a continuous signal at a first optical frequency, an assembly (2) for spectrally and temporally shaping said continuous signal and a photoreceiver (3), the passband of which is in the domain of microwave frequencies,

**characterised in that** the assembly for spectrally and temporally shaping comprises at least:

- one first Y-shaped optical splitter (20) disposed at the output of the laser;
- one first optical channel disposed at the output (22) of the first branch of the first Y-shaped optical splitter, said first optical channel being a frequency shift loop, said frequency shift loop comprising an X-shaped optical splitter (50), a first optical amplifier (60), a first optical filter (75), an optical isolator (70) and an acousto-optical frequency shifter (80) disposed between two branches of the X-shaped optical splitter;

- a second optical channel disposed at the output (23) of the second branch of the first Y-shaped optical splitter, said second optical channel comprising an electro-optical frequency shifter (30);
- a second Y-shaped optical splitter (40), the first branch (42) of which is disposed at the output of the first optical channel and the second branch (43) of which is disposed at the output of the second optical channel;
- a second optical amplifier (90) disposed at the common output (41) of the second Y-shaped optical splitter;
- a second optical filter (100) disposed between the output of the second optical amplifier and the photoreceiver;

with at least the acousto-optical shift frequency (80), the electro-optical shift frequency (30) and the amplification gain of the first optical amplifier (60) being adjustable.

2. The device for photonic generation of arbitrary microwave signals as claimed in claim 1, **characterised in that** all or part of the device is fibre, the laser being fibre, the first Y-shaped optical splitter being a first Y-shaped optical coupler, the second Y-shaped optical splitter being a second Y-shaped optical coupler and the X-shaped optical splitter being an X-shaped optical coupler.

3. The device for photonic generation of arbitrary microwave signals as claimed in claim 1, **characterised in that** all or part of the device is produced in integrated optics.

4. The device for photonic generation of arbitrary microwave signals as claimed in claim 1, **characterised in that** all or part of the device is produced using discrete optical components, the first Y-shaped optical splitter being a first splitter cube comprising a semi-reflective plate, the second Y-shaped optical splitter being a second splitter cube comprising a semi-reflective plate and the X-shaped optical splitter being a splitter cube comprising a semi-reflective plate.

5. The device for photonic generation of arbitrary microwave signals as claimed in any one of the preceding claims, **characterised in that** the first optical filter (75) is of the optical band-pass type.

6. The device for photonic generation of arbitrary microwave signals as claimed in any one of the preceding claims, **characterised in that** the second optical filter (100) is either an optical band-pass type spectral filter or an intensity modulation filter.

7. The device for photonic generation of arbitrary microwave signals as claimed in any one of the preceding claims, **characterised in that** the product of multiplying the acousto-optical shift frequency by the travel time of the light passing through the frequency shift loop is substantially equal to a whole number or to a fractional number.

8. The device for photonic generation of arbitrary microwave signals as claimed in any one of the preceding claims, **characterised in that** the acousto-optical shift frequency is between 1 and 300 MHz.

9. The device for photonic generation of arbitrary microwave signals as claimed in any one of the preceding claims, **characterised in that** the electro-optical frequency shifter is a single sideband modulator.

10. The device for photonic generation of arbitrary microwave signals as claimed in any one of the preceding claims, **characterised in that** the electro-optical shift frequency is between -40 GHz and +40 GHz.

11. The device for photonic generation of arbitrary microwave signals as claimed in any one of the preceding claims, **characterised in that** the gain of the first amplifier is at least sufficient for compensating for the optical losses in the X-shaped optical splitter, the optical isolator, the acousto-optical frequency shifter.

SIGNAL OPTIQUE
EN SORTIE
DU MODULATEUR

SIGNAL OPTIQUE
EN SORTIE
DE LA LIGNE DISPERSIVE

# FIG. 1

# FIG. 2

FIG. 3

A

$S_0$

$f_0$

f

FIG. 4

A

$S_{1k}$

$S_{1K}$

G=P

$f_S$

f

FIG. 5

A

$S_{1k}$

G<P

$f_S$

f

FIG. 6

A

$S_2$

$f_0$

$f_e$

f

FIG. 7

A

BP

$f_0$

$f_{0+}f_e$

f

FIG.8

$$f_S/f_C = a - \varepsilon$$

FIG. 9

$$f_S/f_C = a + \varepsilon$$

FIG. 10

EP 3 369 172 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- CN 102255224
- US 2007189341 A
- US 7777940 B

**Littérature non-brevet citée dans la description**

- **J. YAO.** Microwave photonics. *J. Lightwave Tech.,* 2009
- **H. GUILLET DE CHATELLUS et al.** Génération of ultrahigh and tunable répétition rates in CW injection seeded frequency shifted feedback lasers », Opt. Exp. 21, 15065 (2013) et « Theory of Talbot lasers. *Phys. Rev A,* 2013, vol. 88, 033828